# EUROPÄISCHE PATENTSCHRIFT

(11) **EP 0 400 176 B1**
(45) Veröffentlichungstag und Bekanntmachung des Hinweises auf die Patenterteilung: **26.07.2000**
(21) Anmeldenummer: 89109835.2
(22) Anmeldetag: 31.05.1989
(51) Int. Cl.: H01L 31/0232, H01L 33/00, G02B 6/42, G09F 9/33

(54) **Verfahren zum Montieren eines oberflächenmontierbaren Opto-Bauelements**
Method to mount a surface-mountable optical element
Procédé pour fixer un élément optique fixable sur une surface

(43) Veröffentlichungstag der Anmeldung: 05.12.1990
(60) Teilanmeldung: 99124677.8
(73) Patentinhaber: Osram Opto Semiconductors GmbH & Co. oHG, 93049 Regensburg (DE)
(72) Erfinder: Waitl, Günter, D-8400 Regensburg (DE); Schellhorn, Franz, D-8400 Regensburg (DE)
(74) Vertreter: Epping, Wilhelm, Dipl.-Ing.

(56) Entgegenhaltungen:
- EP-A- 0 230 336
- WO-A-83/00408
- DE-A- 3 703 423
- FR-A- 2 520 935
- US-A- 4 000 437
- US-A- 4 439 006
- IBM Technical Disclosure Bulletin, vol. 13, Nr. 3, August 1970, Seite 591, New York, (USA) L.B. RICHARDS: "Photodetector as function detector"

## Beschreibung

Die Erfindung betrifft ein Verfahren zum Montieren eines oberflächenmontierbaren Opto-Bauelements.

SMD (Surface Mounced Devices) steht für eine neue Aufbautechnik von Flachbaugruppen. Es umfaßt sowohl eine neue Art der Verarbeitung der Bauelement, nämlich die Oberflächenmontage, als auch eine neue Generation von Bauelementen, die zu der neuen Technik passen müssen.

Die Oberflächenmontage wird die herkömmliche Technik der Einsteckmontage mehr und mehr ablösen. Oberflächenmontage heißt, daß unbedrahtete Bauelemente anstelle von bedrahteten auf eine Leiterplatte oder auf ein sonstiges Substrat gebracht werden. Mit SMD können weitere Vorteile genutzt werden: Die Flachbaugruppen werden bis zu 70 % kleiner, die Fertigung wird rationeller, die Zuverlässigkeit wird größer.

Die oberflächenmontierbaren Bauelemente sind dann wirtschaftlich zu verwenden, wenn sie in Bestückautomaten verarbeitet werden. Die Vorteile der Oberflächenmontage sind um so größer, je besser Bauelemente, Leiterplatten-Layout, automatische Bestückung, Löttechnik, Prüfen aufeinander abgestimmt sind.

Oberflächenmontierbare Opto-Bauelemente sind aus EP-A-0 083 627 bekannt. Dabei ist in einer Vertiefung eines Substrats aus Keramikmaterial ein optoelektronischer Halbleiterkörper angeordnet. Über dem Halbleiterkörper ist eine aus Epoxidharz bestehende lichtdurchlässige Schicht mit domartiger Wölbung angeordnet. Dieses bekannte Bauelement ist im wesentlichen für Display-Anordnungen gedacht. Bei einer solchen Displayanordnung ist über dem Bauelement ein Reflektor angeordnet, der auf einer Leiterplatte mittels Justierhilfen positioniert ist.

Darüberhinaus ist aus EP-A-0230 336 ein optoelektronisches Bauelement bekannt, bei dem über einer auf einem Substrat angeordneten LED eine Kugellinse angeordnet ist. Die Kugellinse ist in einem ringförmigen Abstandhalter eingefaßt, der auf dem Substrat befestigt ist und die LED umschleißt.

Ergänzend dazu ist die US-A-4,439,006 zu nennen, in der beschrieben ist, zur Justierung einer optischen Einrichtung Justierhilfen zu verwenden.

Der vorliegenden Erfindung liegt die Aufgabe zugrunde, ein Verfahren zum Montieren eines oberflächenmontierbaren Opto-Bauelements anzugeben, das kostengünstig ist und mit dem es möglich ist, Bauelemente zu montieren, die auf den handelsüblichen Bestückautomaten der SMD-Technik verarbeitbar sind.

Weiterhin soll das Opto-Bauelement flexibel einsetzbar sein, d. h. gleiche Grundkörper sollen mit unterschiedlichen optischen Einrichtungen versehen werden können und umgekehrt. Außerdem soll dieses Opto-Bauelement eine hohe Positioniergenauigkeit zwischen dem Grundkörper und der optischen Einrichtung aufweisen.

Diese Aufgabe wird erfindungsgemäß durch ein Verfahren mit den Merkmalen des Anspruches 1 gelöst.

Ausgestaltungen und Vorteile der Erfindung sind in den Unteransprüchen, der Beschreibung und den Zeichnungen angegeben.

Bei der vorliegenden Erfindung ist es möglich, daß die optische Einrichtung zur Formung des abzustrahlenden und/oder zu empfangenden Lichts so auf dem Grundkörper aufliegt, daß zwischen der optischen Einrichtung und dem Grundkörper seitlich praktisch kein Licht verloren geht.

Bei der vorliegenden Erfindung werden Sender- und/oder Empfänger in Vertiefungen des Grundkörpers angeordnet. Dadurch wird ein Übersprechen zwischen verschiedenen Sendern auf einer Leiterplatte oder auf einem Substrat, auf dem mehrere Grundkörper angeordnet sind, vermieden. Eine solche Vertiefung kann in einfacher Weise als Reflektor ausgebildet werden.

Wenn ein Empfänger in einer Vertiefung angeordnet wird, so ist das Nutz-Stör-Signal-Verhältnis deutlich verbessert wegen der verringerten Seitenlicht-Empfindlichkeit.

Da bei der vorliegenden Erfindung der Grundkörper keine domartige Wölbung an seiner Oberfläche aufweist, ist er mit Hilfe einer Bestückungsvorrichtung genauer positionierbar.

Auch die Positioniergenauigkeit zwischen Grundkörper und der optischen Einrichtung ist bei dem nach der vorliegenden Erfindung hergestellten Opto-Bauelement größer als die Positioniergenauigkeit eines Reflektors bezüglich des aus EP-A-0083627 bekannten Bauelements, welches die bekannte domartige Wölbung an seiner Oberfläche aufweist. Daraus ergeben sich konstantere Auskoppelverhältnisse und ein besserer Eindruck beim Betrachter.

Der Grundkörper besitzt eine im wesentlichen plane Oberfläche, was für die Bestücktechnik günstig ist.

Vorteilhafterweise sind sowohl im Grundkörper als auch in der optischen Einrichtung Justierhilfen angeformt, beispielsweise in Form von Zapfen, Klammern, Nuten, Bohrungen, Vertiefungen, die auch zur Befestigung der optischen Einrichtung am Grundkörper dienen.

Es kann eine einzige optische Einrichtung für mehrere Grundkörper vorgesehen sein. Umgekehrt können mehrere optische Einrichtungen für einen Grundkörper verwendet werden.

Die Erfindung ermöglicht die Herstellung von oberflächenmontierbaren Opto-Bauelementen mit variabler Optik bei geringem Herstellungsaufwand. Für jede Variation in der Optik mußte beim Stand der Technik ein extra angepaßtes Gehäuse hergestellt werden. Dies erfordert hohe Investitionen im Bereich der Endmontage, insbesondere bei der Bauteilumhüllung. Zusätzlich engen die Montagemöglichkeiten der SMD-Bestückautomaten die Gestaltung der Optik ein.

Die Erfindung ermöglicht die Herstellung oberflächenmontierbarer Bauformen (Grundbauelemente), die kostengünstig herstellbar, auf den handelsüblichen Bestückautomaten verarbeitbar sind und bei denen es möglich ist, daß erst nach dem Monatage- und Löt-Prozeß diese Grundbauelemente mit einer dem jeweiligen Anwendungsfall angepaßten Optik gekoppelt werden.

Durch die Trennung von Grundkörper und Optik (optischer Einrichtung) wird die Anzahl der Bauformen stark reduziert. Die hohen Anforderungen, die an ein SMD-Bauelement bezüglich der Montierbarkeit und der Lötbarkeit gestellt werden, sind mit einem Bauelement nach der Erfindung sicherer zu realisieren. Die Gestaltung der Optik kann hinsichtlich Design und Materialauswahl wesentlich besser an den jeweiligen Anwendungsfall optimiert werden.

Das Grundbauelement (der Grundkörper) enthält die optischen Sender und/oder Empfänger. Bei optischen Sendern ist es vorteilhaft, die Halbleiterbauelemente in einem Reflektor zu montieren. Dieser Reflektor kann entweder als Prägung in einem Metallträger oder durch Umhüllung mit einem reflektierenden, gegebenenfalls hochreflektierenden, Kunststoff ausgebildet werden. Eine Kombination aus Prägung in einem Metallträger und Umhüllung mit einem reflektierenden Kunststoff ist ebenfalls möglich. Die Außenform der Bauelemente ist so gestaltet, daß die für die Bestücktechnik günstige, im wesentliche plane Oberfläche des Grundkörpers vorhanden ist und daß zusätzlich für die Verbindung des Grundkörpers mit der Optik im Grundkörper Justierhilfen angeformt sind.

Die Optik (die optische Einrichtung) wird nach dem jeweiligen Anwendungsfall gestaltet (designed). Es lassen sich Opto-Bauelemente mit engen oder weiten Abstrahl- bzw. Empfangs-Charakteristiken realisieren. Bei Verwendung von Umlenkeinrichtungen in der optischen Einrichtung kann die Sende- oder Empfangsrichtung um einen Winkel, beispielsweise um 90°, gedreht werden. Dadurch ist es möglich, daß sich sogenannte Side-Looker-Bauformen erübrigen. Bei Side-Looker-Bauformen blickt der Sender bzw. der Empfänger des Bauelements in eine Richtung parallel zur Oberfläche des Substrats, auf dem das Bauelement angeordnet ist.

Wird anstelle einer Linsenoptik mit Hilfe einer optischen Einrichtung ein Lichtwellenleiter adaptiert, so erhält man ein SMD-fähiges Lichtwellenleiter(LWL)-Bauelement.

SMD-Bauelemente sind aus EP-A-0 218 832, aus DE-A-32 31 277 und aus der PCT-Patentanmeldung WO-A-85/01634 bekannt.

Die Erfindung wird im folgenden anhand der Zeichnung näher erläutert.
FIG 1 zeigt schematisch mögliche Grundkörper.
FIG 2 und 3 erläutern die Herstellung von Grundkörpern.
FIG 4 bis FIG 20 zeigen mögliche Ausführungsformen von Opto-Bauelementen.

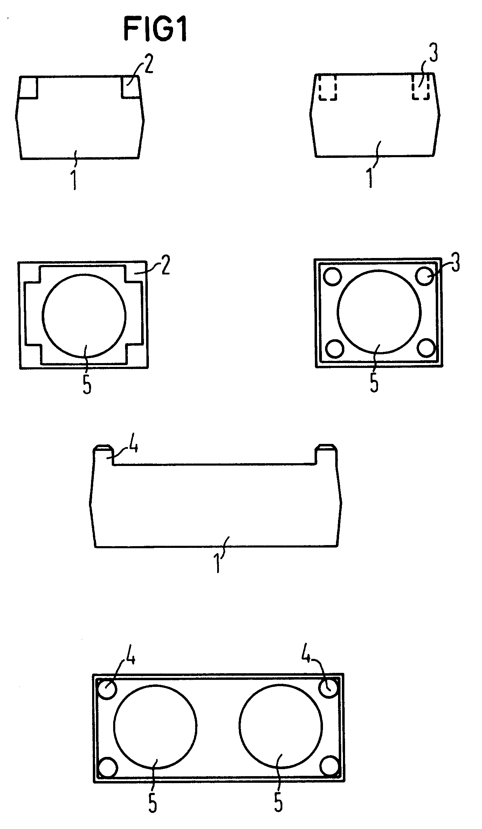

FIG 1 zeigt schematisch mögliche Ausführungsformen für Grundkörper 1. Die Grundkörper 1 enthalten mindestens eine Vertiefung 5, in der optische Sender und/oder optische Empfänger angeordnet sind. Diese Vertiefungen können vorteilhafterweise bei optischen Sendern als Reflektoren ausgebildet sein. Die Vertiefungen 5 sind vorteilhafterweise mit Kunststoff, beispielsweise mit Gießharz vergossen. Diejenige Oberfläche des Grundkörpers 1, die von demjenigen Substrat, auf das der Grundkörper 1 montiert wird, abgewandt ist, ist im wesentlichen plan. Dies bedeutet, daß die plane Oberfläche von einer Vorrichtung zum Bestücken von Bauelementen automatisch und mit hoher Taktgeschwindigkeit angesaugt werden kann. Daher können Grundkörper 1 mit einer planen Oberfläche sehr rasch und sehr präzise auf einem Substrat, beispielsweise auf einer Leiterplatte, positioniert werden. Die Grundkörper 1 können zur besseren Justierung der optischen Einrichtungen auf diesen Grundkörpern 1 mit Nuten 2, Bohrungen 3 oder Zapfen 4 versehen sein. Darüber hinaus sind eine Fülle von weiteren Justierhilfen zur Befestigung von optischen Einrichtungen bezüglich der Grundkörper 1 möglich und dem Fachmann zugänglich.

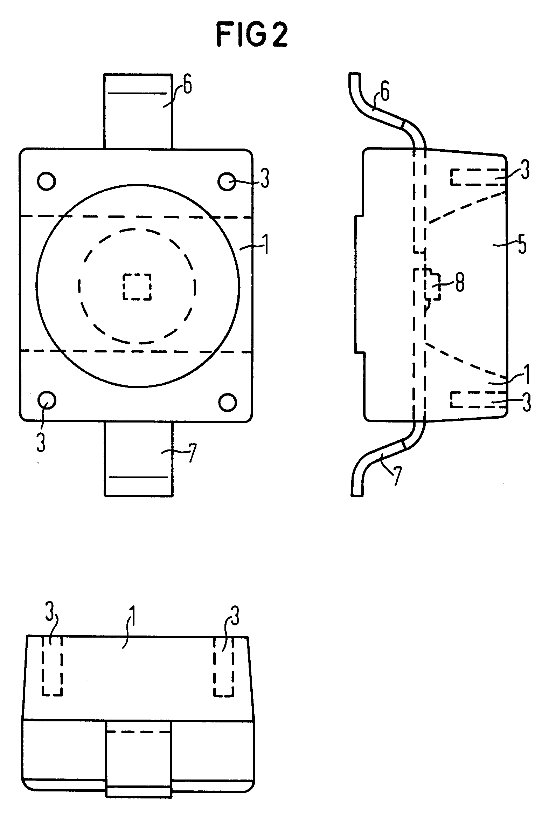

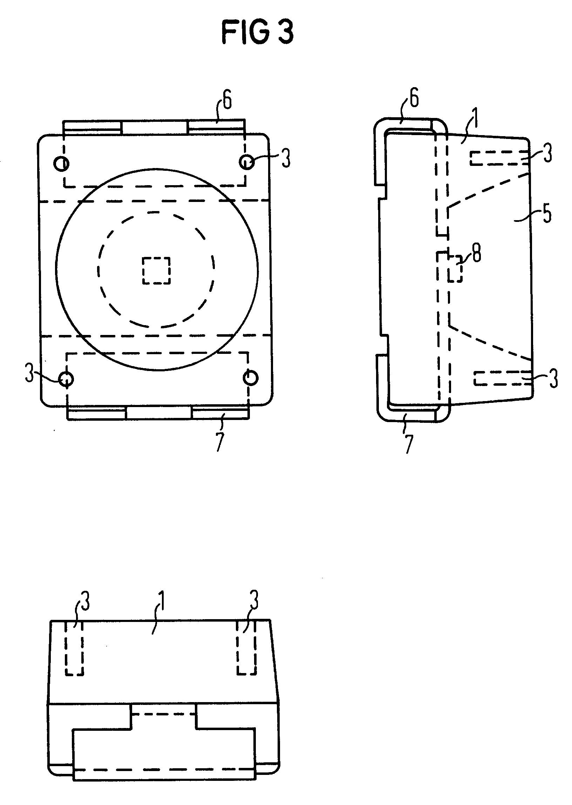

FIG 2 und 3 erläutern die Herstellung von Grundkörpern 1. Die elektrischen Anschlüsse 6, 7 werden während des Aufbringens des Halbleiterkörpers 8 und der Bond-Draht-Verbindung zwischen dem Halbleiterkörper 8 und dem elektrischen Anschluß 6 in sogenannter Leiterrahmen-Technik (lead-frame-Technik) zusammengehalten. Erst nach Herstellung der Bond-Draht-Verbindung werden der Halbleiterkörper 8, der Bond-Draht und Teile der elektrischen Anschlüsse 6, 7 mit Kunststoff wie z. B. Duroplasten oder Thermoplasten umpreßt oder umgossen. Es kann auch zuerst der Leiterrahmen (leadframe) mit Kunststoff, beispielsweise mit Thermoplast, umspritzt werden, und erst dann im Inneren der Vertiefung 5 ein Halbleiterkörper 8 angeordnet werden. Schließlich kann die Vertiefung 5 mit Gießharz ausgegossen werden. In der Umhüllung des Grundkörpers 1 können Justierhilfen wie z. B. Bohrungen 3 vorgesehen sein. Die elektrischen Anschlüsse 6, 7 können in dem Bereich, in dem sie aus der Umhüllung des Grundkörpers 1 herausragen, so gebogen sein, daß sie wie bei FIG 2 von der Umhüllung des Grundkörkörpers 1 wegschauen, oder daß sie wie bei FIG 3 nach unten zur Mitte der Umhüllung des Grundkörpers hin gebogen sind.

Für den Grundkörper 1 werden bei der Erfindung nur wenige Grundformen benötigt. Außerdem ist Kunststoffmaterial, das die bei der Oberflächenmontage auftretenden hohen Temperaturen und sonstigen Belastungen aushält, nur in geringem Umfang erforderlich. Für die Umhüllung des Grundkörpers 1 können alle SMD-fähien Materialien verwendet werden. Für die Umhüllung des Grundkörpers 1 kann beispielsweise LCP (Liquid Crystal Polymer)-Material verwendet werden. Obwohl nur wenige Grundformen 1 benötigt werden, ermöglicht die Erfindung eine große Gestaltungsfreiheit bei der Ausgestaltung von Opto-Bauelementen.

Wird ein Thermoplast für die Umhüllung des Grundkörpers 1 verwendet, so hält dieser Kunststoff die üblichen Löt-Temperaturen zwischen 200 und 280°C aus.

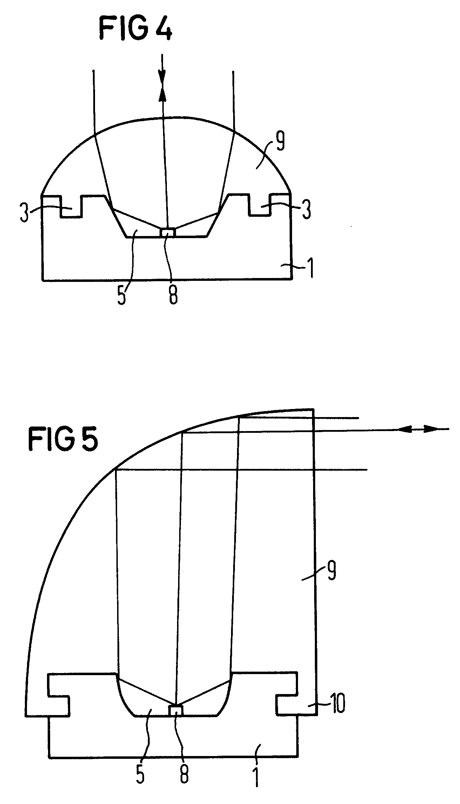

FIG 4 bis 20 erläutern mögliche Ausführungsformen von Opto-Bauelementen nach der Erfindung. FIG 4 zeigt einen Grundkörper 1 mit einem optischen Sender 8 in einem Reflektor 5. In Bohrungen 3 des Grundkörpers 1 sind Zapfen einer optischen Einrichtung 9 eingesteckt. Die optische Einrichtung 9 ist mit diesen Zapfen einstückig ausgebildet. Als optische Einrichtung 9 können Vollguß-Körper Verwendung finden. Als optische Einrichtung 9 können beispielsweise Glaslinsen mit einem bestimmten Brechungsindex verwendet werden. Als optische Einrichtung 9 können jedoch auch sonstige Einrichtungen verwendet werden, die das von den optischen Sender bzw. optischen Empfänger 8 ausgehende bzw. empfangene Licht in irgendeiner Weise formen, bündeln oder gestalten. Die Erfindung ermöglicht es, für die optische Einrichtung 9 ein Material zu verwenden, daß nicht unbedingt auf Dauer hohe Temperaturen aushalten können muß. Beispielsweise kann für die optische Einrichtung 9 Polycarbonat (für Linsen glasklar oder für Display weiß gefüllt) verwendet werden. Für die optische Einrichtung 9 kann auch ein preisgünstiger Kunststoff wie Pocan (Polybutylen-terephthalat) Verwendung finden. Solche Kunststoffe halten beispielsweise eine Dauertemperatur bis zu 150° C aus.

Die optische Einrichtung 9 in FIG 4 ist beispielsweise als Sammellinse ausgeführt. Dabei wird paralleles Licht in gebündeltes Licht umgewandelt und umgekehrt. Durch Gestaltung von Vertiefung (Reflektor) 5 und/oder optischer Einrichtung 9 kann eine Vielfalt von Abstrahl- und/oder Empfangs-Charakteristiken erzielt werden. So kann für jeden beliebigen Anwendungsfall die dafür am besten geeignete Gehäuseform bei Verwendung von nur einigen wenigen Grundkörpern 1 hergestellt werden.

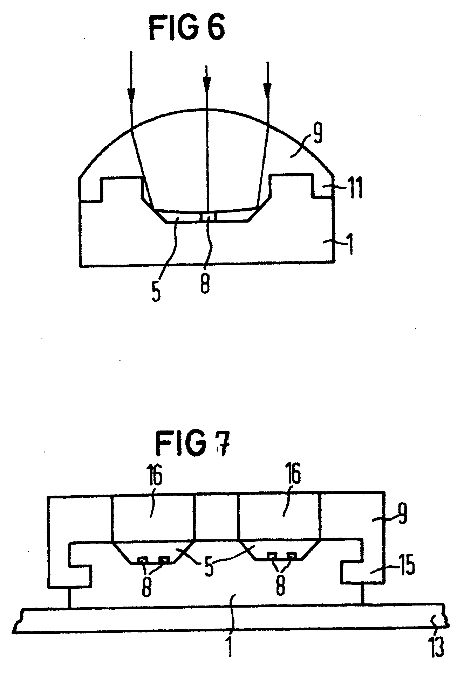

FIG 5 zeigt ein Opto-Bauelement, bei dem die optische Einrichtung 9 so gestaltet ist, daß das vom optischen Sender und/oder optischen Empfänger 8 ausgehende bzw. empfangene Licht um 90° umgelenkt wird. Dabei weisen die Lichteintritts- und/oder Lichtaustrittsflächen der optischen Einrichtung 9 reflektierende Kurven und linsenförmige Kurven auf. Solche Abstrahl- bzw. Empfangscharakteristiken sind in DE-GM 85 00 013.2 (US-Patent US-A-4638343, angemeldet am 15. April 1985) beschrieben.

In FIG 5 ist die optische Einrichtung 9 mit Klammern 10 einstückig ausgebildet. Die Klammern 10 finden Halt in Kerben oder Nuten des Grundkörpers 1.

FIG 6 zeigt ein Opto-Bauelement mit einem Grundkörper 1, bei dem in einer Vertiefung 5 ein Halbleiter-Detektor angeordnet ist. Die optische Einrichtung 9 besitzt an ihrem äußeren Rand einen Vorsprung, der auf Kerben 11 des Grundkörpers 1 aufgesteckt wird.

Der Grundkörper 1 kann auch aus einem anderen Material als aus Kunststoffmaterial hergestellt sein.

Die optische Einrichtung 9 kann in einfacher Weise so gestaltet sein, daß sie so auf den Grundkörper 1 aufgesetzt wird, daß seitlich zwischen Grundkörper und optischer Einrichtung praktisch kein Licht austreten kann.

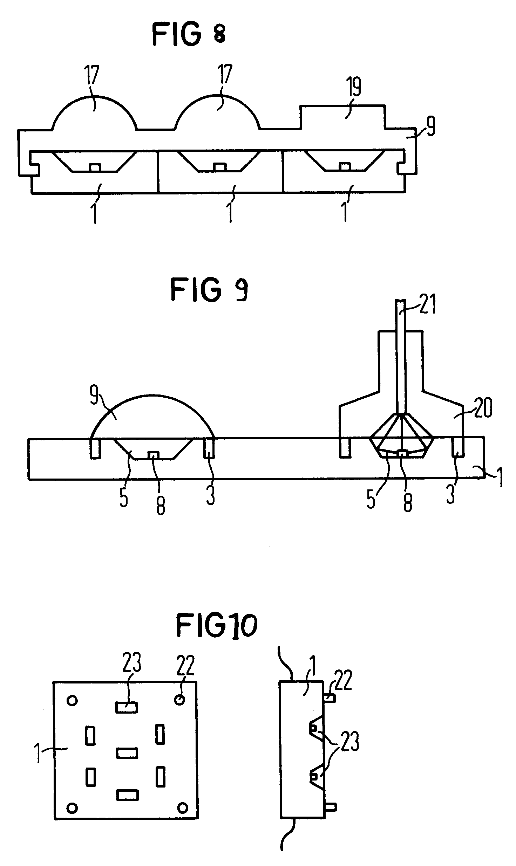

Die Figur 7 zeigt ein Display-Bauelement, bei dem unterschiedliche Anzahlen von Sendern und/oder Empfängern 8 in mehreren Vertiefungen 5 angeordnet sind. Die Strahlformung kann bei der vorliegenden Erfindung generell so gestaltet sein, daß sowohl durch die Formgebung der Vertiefungen 5 als auch durch die Ausbildung der optischen Einrichtung 9 jeweils ein Beitrag zur Strahlformung geliefert wird.

In Figur 7 besitzt die optische Einrichtung 9 Klammern 15, die in Kerben des Grundkörpers 1 einschnappen. In Figur 7 besitzt die optische Einrichtung 9 Öffnungen 16, die die Öffnungen der Vertiefungen 5 in Grundkörper 1 optisch nicht zusätzlich aufweiten.

Figur 8 zeigt ein Opto-Bauelement, bei dem drei Grundkörper 1 nebeneinander angeordnet sind. Auf diesen drei Grundkörpern 1 ist eine optische Einrichtung 9 aufgebracht. Dabei befindet sich über zwei Sendern und/oder Empfängern jeweils eine Linse 17, während über einem dritten Halbleiterbauelement eine Leuchtfläche 19 angebracht ist. Eine solche Leuchtfläche 19 mit zugehörigem Halbleiterbauelement ist beispielsweise in DE-GM 87 13 875.1 beschrieben. Die Umhüllung des zugehörigen Halbleiterbauelements weist dabei eine als Konkavlinse ausgeführte Lichtaustrittsfläche zur Abstrahlung von Licht in einen möglichst großen Raumwinkel auf. Die Leuchtfläche 19 besitzt dabei die Eigenschaft einer Streuscheibe.

FIG 9 zeigt einen einzelnen Grundkörper 1 mit zwei Vertiefungen 5. Über der ersten Vertiefung 5 ist eine Linse als optische Einrichtung 9 angebracht. Über der zweiten Vertiefung 5 ist eine Einrichtung 20 zur Erzeugung einer lösbaren Faserverbindung angebracht. Die Vorrichtung 20 stellt praktisch einen Lichtleiterverbinder dar. Die Vorrichtung 20 ist auf einem Lichtwellenleiter 21 aufgebracht. Ein Opto-Bauelement mit einem Lichtleiterverbinder kann für einen Teilnehmeranschluß bei einem faseroptischen Kommunikationsnetz Verwendung finden. Ein solches OptoBauelement mit einem Lichtleiter-Verbinder kann auch bei sonstigen faseroptischen Systemen wie beispielsweise in Automobilen eingesetzt werden. Im Grundkörper 1 können selbstverständlich auch integrierte Schaltungen Verwendung finden. Eine Einrichtung kann selbstverständlich auch mit Klammern an einem Grundkörper 1 befestigt werden.

Eine Einrichtung nach FIG 9 erübrigt das Bereitstellen eines Halterungsteiles zum Einstecken eines Lichtleiters. Dadurch kann auf eine zusätzliche Positioniertoleranz für das Einstecken eines Lichtleiters verzichtet werden. Dadurch ist eine zusätzliche Miniaturisierung bei einem Opto-Bauelement mit einer Einrichtung möglich.

In einer einzigen Vertiefung 5 können sowohl optische Sender als auch optische Empfänger als auch integrierte Schaltungen angeordnet werden.

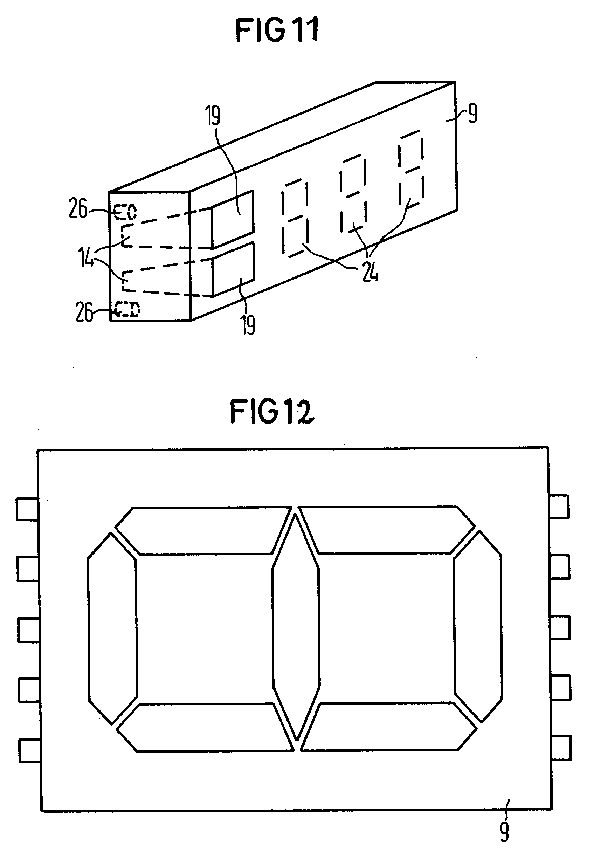

FIG 10 und 11 zeigen einen Grundkörper 1 und zugehörige optische Einrichtung 9. Ein Grundkörper 1 nach FIG 10 gehört zu einer sogenannten 7-Segment-Anzeige. Ein solcher Grundkörper zeigt sieben Lichtschächte 23. Der Grundkörper 1 besitzt außerdem Zapfen 22 zum Befestigen der optischen Einrichtung 9 von FIG 11.

Über mehreren Grundkörpern 1, welche nebeneinander auf einem Substrat montiert sind, wird eine optische Einrichtung 9 nach FIG 11 angeordnet. Die optische Einrichtung 9 von FIG 11 besitzt sich aufweitende Öffnungen 14 zur Darstellung von 7-SegmentAnzeigen 24. Außerdem besitzt die optische Einrichtung 9 von FIG 11 zwei Leuchtflächen 19. Schließlich besitzt die optische Einrichtung 9 von FIG 11 noch Öffnungen 26 zur Befestigung auf den Zapfen 22 der Grundkörper 1 von FIG 10.

Ein Opto-Bauelement nach der Erfindung ermöglicht eine Vielfalt von optischen Einrichtungen 9 bei Verwendung von nur wenigen Ausführungsformen des Grundkörpers 1.

FIG 12 bis 14 zeigen verschiedene Gestaltungen von 7-Segment-Anzeigen je nach Anwendungswunsch. Obwohl die Anzeigen nach den FIG 12 bis 14 verschiedene Gestaltungen aufweisen, können sie mit Hilfe eines einzigen Grundkörpers 1 gemäß FIG 10 verwirklicht werden. Die Vertiefungen 5 im Grundkörper 1 nach FIG 10 sind nur so weit aufgeweitet, daß durch zusätzliche Aufweitungen 14 in den optischen Einrichtungen 9 nach FIG 12 bis 14 unterschiedliche Anzeigen-Formen erzielt werden können.

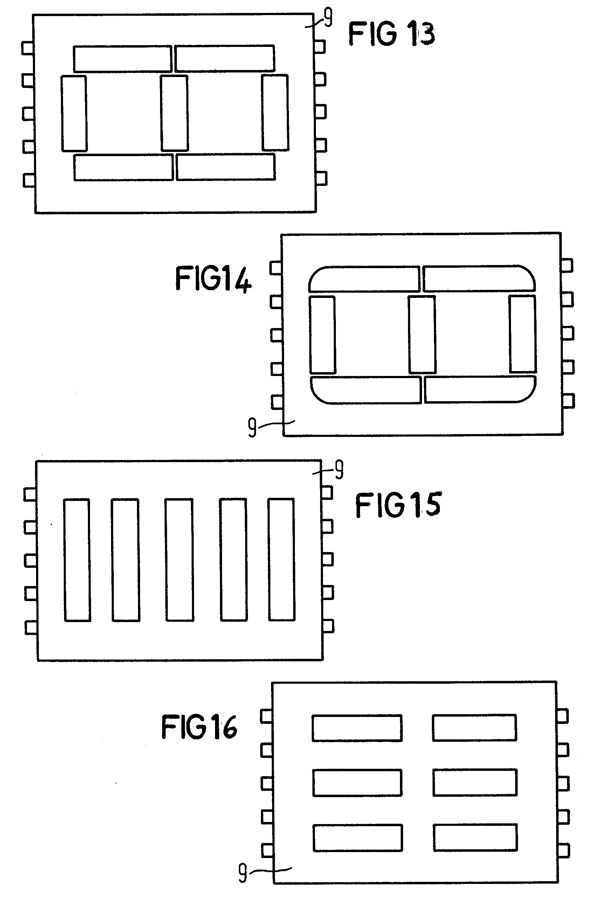

FIG 15 und 16 zeigen optische Einrichtungen 9 mit unterschiedlich angeordneten Lichtbalken.

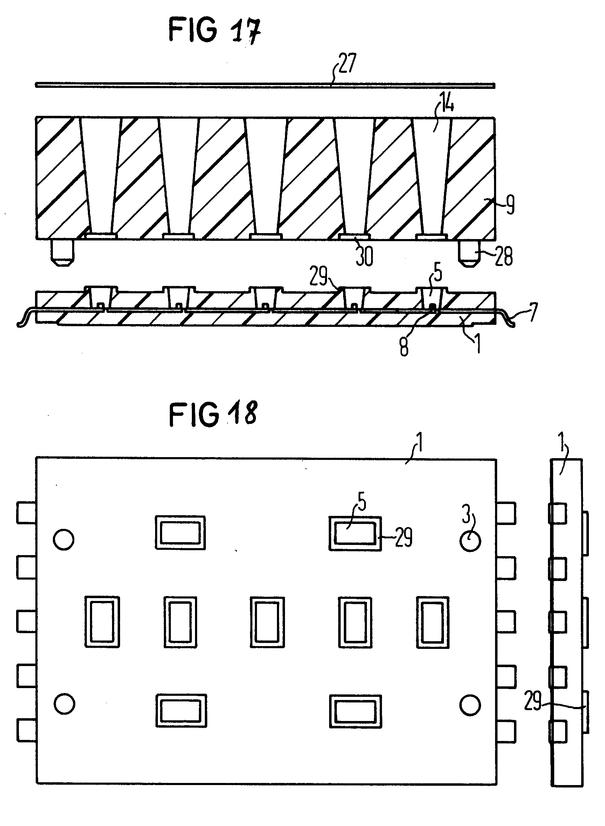

Die FIG 17 bis 20 zeigen einen Grundkörper 1, auf dem sowohl eine optische Einrichtung 9 nach FIG 15 als auch eine optische Einrichtung 9 nach FIG 16 mit unterschiedlich geformten Lichtbalken aufgebracht werden kann. Die optischen Einrichtungen 9 besitzen dabei Zapfen 28, die in Bohrungen 3 des Grundkörpers 1 eingesteckt werden. Im Grundkörper 1 sind optische Sender 8 in Vertiefungen (Reflektoren) 5 angeordnet. Diese Reflektoren 5 sind so gestaltet, daß optische Einrichtungen 9 mit unterschiedlichen Lichtöffnungen 14 aufgesetzt werden können. Zur gleichmäßigen Ausleuchtung der Lichtbalken wird noch eine Streuscheibe (Diffusor) 27 auf die optische Einrichtung 9 aufgebracht.

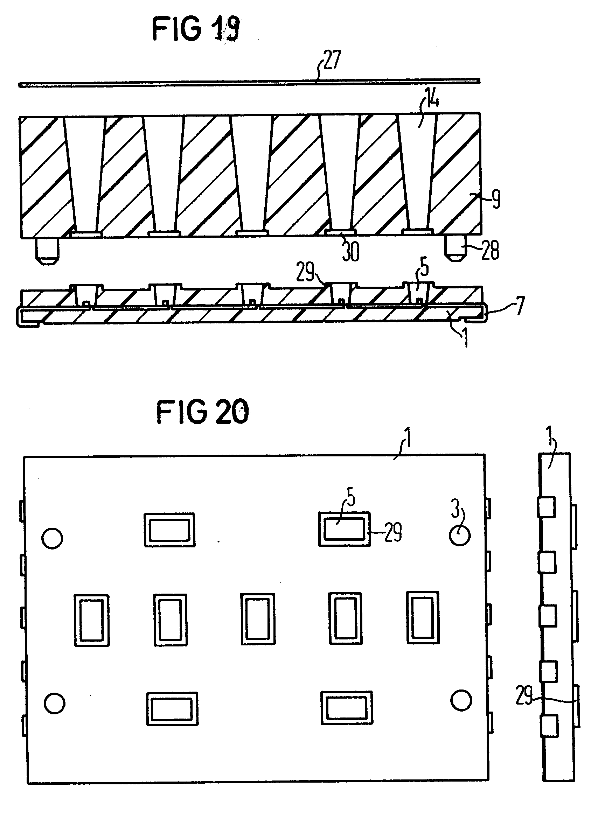

FIG 17 zeigt einen Grundkörper 1, bei dem die Enden der elektrischen Anschlüsse 7 vom Grundkörper weg zeigen. FIG 19 zeigt einen Grundkörper 1, bei dem die Enden der elektrischen Anschlüsse 7 nach unten zum Grundkörper hin gebogen sind.

In den FIG 17 und 19 sind die Ränder 29 der Vertiefungen 5 hochgezogen. Diese Ränder 29 werden in Vertiefungen 30 der optischen Einrichtung 9 eingepaßt. Die hochgezogenen Ränder 29 verhindern ein Übersprechen bei verschiedenen Sendern und/oder verbessern das Nutz-Stör-Signal-Verhältnis, wenn Empfänger in Vertiefungen 5 angeordnet sind.

## Patentansprüche

1. Verfahren zum Montieren eines Opto-Bauelements, das einen oberflächenmontierbaren Grundkörper (1) und wenigstens eine optische Einrichtung zur Formung des abzustrahlenden und/oder zu empfangenden Lichtes (9) aufweist, bei dem der Grundkörper (1), der eine im Wesentlichen plane Oberfläche und justierhilfen zur justierten Befestigung der wenigstens einen optischen Einrichtung aufweist und mindestens eine Vertiefung enthält, in der ein optischer Sender und/oder Empfänger angeordnet ist und die mit Kunststoff vergossen ist, mit Hilfe einer automatischen Bestückvorrichtung auf ein Substrat oberflächenmontiert wird und nach der Montage des Grundkörpers (1) die wenigstens eine optische Einrichtung (9) mittels Justierhilfen auf dem Grundkörper (1) befestigt wird.

2. Verfahren nach Anspruch 1, bei dem in der Vertiefung des Grundkörpers (1) ein optischen Sender angeordnet ist und den Grundkörper einen optischen Reflektor in der Vertiefung für das zu sendende licht aufweist.

3. Verfahren nach Anspruch 1 oder 2, bei dem als Justierhilfen am Grundkörper (1) und an der optischen Einrichtung (9) Zapfen, Klammern, Nuten und/oder Bohrungen vorgesehen sind.

4. Verfahren nach einem der Ansprüche 1 bis 3, bei dem als optische Einrichtung (9) eine Umlenkeinrichtung zur Drehung der Sende- und/oder Empfangs-Richtung des abzustrahlenden und/oder zu empfangenden Lichtes vorgesehen wird.

5. Verfahren nach einem der Ansprüche 1 bis 3, bei dem als optische Einrichtung (9) eine Linsenoptik vorgesehen wird.

6. Verfahren nach einem der Ansprüche 1 bis 3, bei dem als optische Einrichtung (9) eine Leuchtfläche (19) vorgesehen wird.

7. Verfahren nach einem der Ansprüche 1 bis 3, bei dem als optische Einrichtung (9) ein Lichtleiter-Verbinder (20) vorgesehen wird.

8. Verwendung eines Verfahrens gemäß einem der Ansprüche 1 bis 7 zur Herstellung eines Displays.

9. Verwendung eines Verfahrens gemäß einen der Ansprüche 1 bis 6 zur Herstellung eines optischen Arrays.

## Claims

1. Method for mounting an optical component which has a surface-mountable base body (1) and at least one optical device for forming the light (9) to be emitted and/or to be received, in which component the base body (1), which has an essentially planar surface and adjustment aids for adjusted attachment of the at least one optical device, and contains at least one depression in which an optical transmitter and/or receiver is arranged and which is encapsulated with plastic, is surface-mounted on a substrate with the aid of an automatic placement apparatus and, after the base body (1) has been mounted, the at least one optical device (9) is mounted on the base body (1) by means of adjustment aids.

2. Method according to Claim 1, in which an optical transmitter is arranged in the depression in the base body (1), and the base body has an optical reflector in the depression, for the light to be transmitted.

3. Method according to Claim 1 or 2, in which pins, brackets, grooves and/or holes are provided as adjustment aids on the base body (1) and on the optical device (9).

4. Method according to one of Claims 1 to 3, in which a deflection device for rotating the transmitting and/or receiving direction of the light to be emitted and/or to be received is provided as the optical device (9).

5. Method according to one of Claims 1 to 3, in which lens optics are provided as the optical device (9).

6. Method according to one of Claims 1 to 3, in which an illuminated area (19) is provided as the optical device (9).

7. Method according to one of Claims 1 to 3, in which an optical conductor connector (20) is provided as the optical device (9).

8. Use of a method according to one of Claims 1 to 7 in order to produce a display.

9. Use of a method according to one of Claims 1 to 6 in order to produce a optical array.

## Revendications

1. Procédé pour monter un composant optique, qui comporte un composant (1) de base pouvant être monté en surface et au moins un dispositif optique pour conformer la lumière (9) à émettre et/ou à recevoir, dans lequel l'élément (1) de base, qui a une surface sensiblement plane et des moyens auxiliaires d'ajustement pour fixer de manière ajustée le au moins un dispositif optique et qui comporte au moins une cavité dans laquelle est disposé un émetteur et/ou un récepteur optique et qui est remplie de matière plastique, est monté en surface sur un substrat à l'aide d'une machine automatique d'implantation et dans lequel, après le montage de l'élément (1) de base, le au moins un dispositif (9) est fixé sur l'élément (1) de base au moyen d'auxiliaire d'ajustement.

2. Procédé suivant la revendication 1, dans lequel un émetteur optique est monté dans la cavité de l'élément (1) de base et dans lequel l'élément (1) de base comporte un réflecteur optique dans la cavité pour la lumière à émettre.

3. Procédé suivant la revendication 1 ou 2, dans lequel il est prévu comme moyen auxiliaire d'ajustement sur l'élément (1) de base et sur le dispositif (9) optique des tenons, des agrafes, des rainures et/ou des perçages.

4. Procédé suivant l'une des revendications 1 à 3, dans lequel il est prévu comme dispositif (9) optique un dispositif déflecteur pour faire tourner la direction d'émission et/ou la direction de réception de la lumière à émettre et/ou de la lumière à recevoir.

5. Procédé suivant l'une des revendications 1 à 3, dans lequel il est prévu comme dispositif (9) optique une optique à lentille.

6. Procédé suivant l'une des revendications 1 à 3, dans lequel il est prévu comme surface (9) optique, une surface (19) éclairante.

7. Procédé suivant l'une des revendications 1 à 3, dans lequel il est prévu comme dispositif (9) optique, un connecteur (20) de guide lumineux.

8. Utilisation d'un procédé suivant l'une des revendications 1 à 7 pour produire un dispositif d'affichage.

9. Utilisation d'un procédé suivant l'une des revendications 1 à 6 pour produire un réseau optique.
